(19)

Europäisches
Patentamt
European
Patent Office
Office européen
des brevets

(11) **EP 1 835 791 A2**

(12) **EUROPEAN PATENT APPLICATION**

(43) Date of publication:
**19.09.2007 Bulletin 2007/38**

(51) Int Cl.:
*H05K 3/32* (2006.01)  *H01R 43/02* (2006.01)
*B23K 26/02* (2006.01)  *H01L 21/60* (2006.01)

(21) Application number: **07004145.4**

(22) Date of filing: **28.02.2007**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **28.02.2006 JP 2006053038
20.12.2006 JP 2006342060**

(71) Applicant: **Hitachi, Ltd.
Chiyoda-ku
Tokyo (JP)**

(72) Inventors:
• **Watanabe, Hirofumi
Chiyoda-ku
Tokyo 100-8220 (JP)**
• **Yasukawa, Daisuke
Chiyoda-ku
Tokyo 100-8220 (JP)**
• **Suzuki, Masaaki
Hitachinaka-shi
Ibaraki (JP)**

(74) Representative: **Beetz & Partner
Steinsdorfstrasse 10
D-80538 München (DE)**

(54) **Method of laser welding, manufactoring method of control unit, and car electronic control unit**

(57) The invention stabilizes a quality of a laser welding in a terminal in which an outer appearance characteristic is not stabilized, and achieves an improvement of a positioning characteristic at a time of executing the laser welding without generating a cost increase. A hole (8) is formed in a terminal (2) of an integrated circuit sealed by a plastic molding. At a time of welding, a welding operation position is positioned by recognizing the hole (8) in accordance with an image recognition, and a laser welding is executed by irradiating a laser beam to a portion of a terminal (2) and a bus bar (5) positioned near an edge portion of the hole (8). The hole (8) is preferably formed in a circular shape or a similar shape thereto.

# FIG. 3

EP 1 835 791 A2

**Description**

Background of the Invention

1. Field of the Invention

The present invention relates to a car electronic control unit, a manufacturing method of the same and a terminal welding method.

2. Description of Related Art

As a brake apparatus of a motor vehicle, there has been developed an electro mechanical brake apparatus which electrically detects a pedaling pressure of a brake pedal and electromechanically generates a brake force corresponding to the detected pedaling pressure. In the electro mechanical brake apparatus, it is possible to individually control the brake force of each of wheels. Further, there has been considered that a control unit for executing a brake force control is provided in each of the wheels for the control mentioned above. For drive controlling a motor corresponding to an actuator actuating the control unit mentioned above, for example, a caliper, the apparatus is filled with resin so as to be modularized, and a terminal thereof is connected to a bus bar provided in an inner portion of a casing of the control unit in accordance with a welding.

In a general laser welding, in the case that a thickness of a weld terminal is comparatively large, even if a laser weld beam is irradiated at a position where the weld terminal and the bus bar overlap, a melting of a weld position does not reach the bus bar, or reaches only a little even if it reaches. As a result, it is hard to obtain a necessary weld strength.

With regard to the weld between the metal terminals such as the bus bars or the like, there has been known a method of a laser welding in which a weld strength is secured by devising a terminal shape (for example, refer to patent document 1 (JP-A-11-215652). Further, there is a method of welding after punching a hole in the terminal to be connected, and positioning and fixing the terminals (for example, refer to patent document 2 (JP-A-11-297445).

Further, with regard to a laser welding between the terminal mentioned above and the bus bar, they are not welded if they are not in contact with each other, and there is a possibility that a product quality is lowered. Further, in the case that a plurality of connection terminals exist such as the control unit, it is necessary to bring all the terminals into contact with each other. As a method of fixing the weld subjects to each other, there has been known a method of fixing by an electrode (for example, refer to patent document 3 (JP-A-10-263838).

In the conventional general laser welding as mentioned above, in order to obtain the weld strength, for example, there is considered that the weld terminal is made thin. However, even in this case, if an individual difference is great in a reflection coefficient of the laser beam in correspondence to an outer appearance surface state of the weld terminal, the same problem may be generated. In the case of the plastic molding modularized unit, the terminal surface is exposed to a high temperature at a time of being filled with the resin, and it is hard to fix its color. In the case that it is impossible to homogenously align a surface state through a production period of the product, there is considered that a quality dispersion caused by the welding under a fixed condition becomes large and a extraction rate is deteriorated. In order to deal with the problem mentioned above, there can be considered to execute the welding while adjusting one position to one position by a manual procedure, however, in the case that a mass production is necessary and the number of the terminals to be welded is large, it takes a long time to set the condition. Accordingly, a cost is increased and this method is not practical. Further, it is possible to stably absorb the laser welding arc by applying a black marking onto the surface of the welt terminal. However, it is necessary to apply the marking after the resin sealing, and a man hour is increased and a cost increase is generated.

Further, as disclosed in the patent document mentioned above, in the case of considering the structure in which the terminal shape is formed in a complicated shape, not only it takes a long time to weld these connection terminals, but also the cost increased is caused, because the plastic molding modularized integrated circuit apparatus generally has a lot of external connection terminals.

Further, in the conventional general laser welding as mentioned above, in order to stabilize the weld strength, for example, there is considered a method of fixing a plurality of terminals by a metal member before welding. However, in this case, there is generated a position which is not fixed in each of the terminals due to a dimensional dispersion of the terminal to be welded. Accordingly, the materials are not in contact with each other and the welding is incompletely executed, and finally, there is a possibility that a malfunction is generated. Accordingly, the cost increase is caused due to the reduction of the extraction rate.

Brief summary of the invention

An object of the present invention is to solve the problems mentioned above, stabilize a quality of a laser welding in a terminal in which an outer appearance characteristic is not stabilized, and achieve an improvement of a positioning characteristic at a time of executing the laser welding without generating a cost increase.

In order to achieve the object mentioned above, there is provided a method of a laser welding of laser welding a bus bar provided within a resin casing constituting a control unit mounted to a vehicle, and a terminal of an integrated circuit inward surrounded within the control unit and sealed by a plastic molding, wherein a hole is previously provided in a position to be welded to the bus bar corresponding to an end portion in the terminal. Further, a positioning at a time of the laser welding is executed by image recognizing the hole, and the bus bar and the terminal are laser welded in a portion in which the hole is provided.

Preferably, a diameter of the hole provided in the terminal is set to be equal to or less than a diameter of an irradiated laser beam. Further, the laser welding is applied to an edge portion of the hole provided in the terminal.

Further, in accordance with the present invention, at a time of laser welding a plurality of terminals of an integrated circuit of a car electronic control unit, and a plurality of bus bars corresponding to the respective terminals, the terminal and the bus bar are brought into contact with each other by pressing plural combinations between the terminals and the bus bars by a fixing member, and the welding is executed by irradiating a laser beam to the contact position.

Further, in accordance with the present invention, at a time of laser welding a terminal of an integrated circuit of a car electronic control unit and a bus bar, the welding is executed by pressing the terminal or the bus bar in such a manner as to pinch a weld point by a plurality of first fixing members in a laser irradiation surface, pressing the weld point by a second fixing member in an inverse side to the laser irradiation side, and irradiating a laser beam to the contact position.

Effect of the Invention

In accordance with the present invention, it is possible to achieve a stable weld quality at a low cost up to a certain degree of terminal thickness regardless of an outer appearance state of the weld terminal and metal plate.

Other objects, features and advantages of the invention will become apparent from the following description of the embodiments of the invention taken in conjunction with the accompanying drawings.

Brief description of the several views of the drawing

Fig. 1 is a schematic view of an integrated circuit apparatus sealed by a plastic molding;
Fig. 2 is a schematic view showing an assembled state of the integrated circuit apparatus to a resin casing;
Fig. 3 is an enlarged perspective view of a welding operation portion 3;
Fig. 4 is a top elevational and cross sectional view of the welding operation portion;
Fig. 5 is an enlarged perspective view of a welding operation portion in accordance with a second embodiment;
Fig. 6 is a top elevational view and a cross sectional view of the welding operation portion in accordance with the second embodiment;
Fig. 7 is a top elevational view and a cross sectional view of a welding operation portion in accordance with a third embodiment;
Fig. 8 is a schematic view showing a terminal fixing state using a fixing member at a time of assembling an integrated circuit apparatus to a resin casing in accordance with a fourth embodiment;
Figs. 9A and 9B are cross sectional views showing a fixed state of the fixing member 15 in Fig. 8 by a rigid body;
Fig. 10 is a perspective view in the case that an elastic body 18 is provided in the fixing member 15 in accordance with the fourth embodiment;
Figs. 11A and 11B are cross sectional views of a fixed state in Fig. 10;
Fig. 12 is a perspective view of a weld position in accordance with a fifth embodiment;
Fig. 13 is a cross sectional view of a fixed state in Fig. 12;
Fig. 14 is a perspective view of a weld position in accordance with a sixth embodiment;
Fig. 15 is a schematic view of a welding apparatus using a fixing method in Fig. 14;
Fig. 16 is a schematic view for theoretically explaining threshold values of a pressing force and a displacement amount of the weld apparatus in Fig. 15;
Figs. 17A and 17B are schematic views for explaining a contact state of a laser welding, with regard to the fixing method shown in Fig. 14;
Fig. 18 is a perspective view of an electro mechanical brake in accordance with a seventh embodiment;
Figs. 19A to 19C are connection diagrams between a caliper DMP and an interface module 200 in Fig. 18;
Fig. 20 is a connection diagram between the interface module 200 and a casing DCP in Fig. 18;

Fig. 21 shows a step at a time of attaching a power module 408 to an inner case 300, in the embodiment in Fig. 18; and
Fig. 22 shows a step at a time of attaching the power module 408 to the inner case 300, in the embodiment in Fig. 18.

Detailed description of the invention

A description will be given below of embodiments in accordance with the present invention with reference to the accompanying drawings.

Embodiment 1

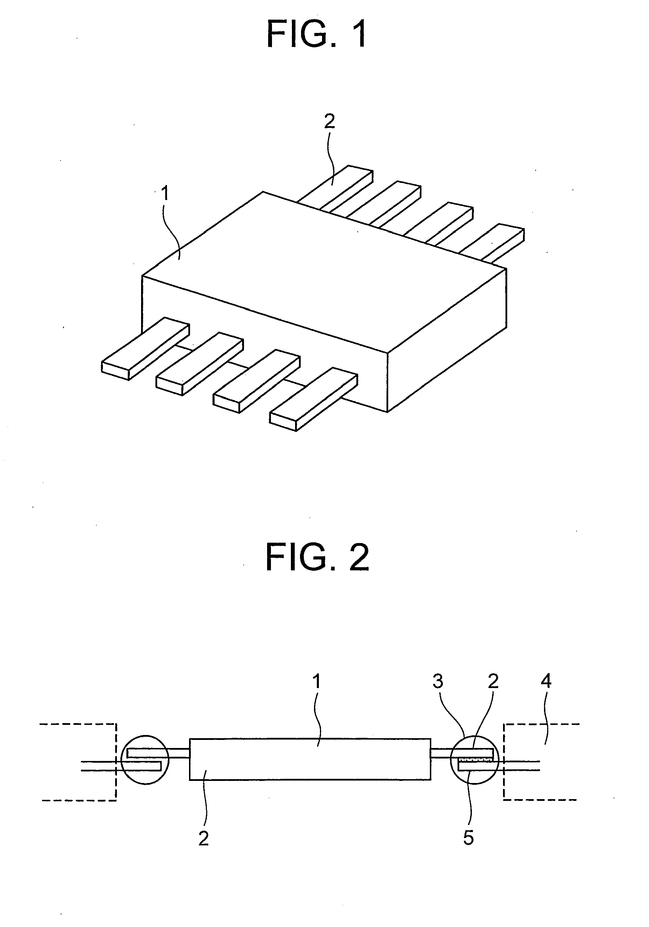

Fig. 1 is a schematic view of a resin-sealed integrated circuit apparatus to which a laser welding in accordance with the present invention is applied.

The integrated circuit apparatus is constituted by having a main body portion 1 structured by sealing an integrated circuit by resin, a terminal 2 provided in such a manner as to protrude from the main body portion 1 sealed by a plastic molding for inputting and outputting a signal to and from the integrated circuit and supplying an electric power. Each of the terminals 2 is provided with a hole for welding to a bus bar. The integrated circuit apparatus is specifically achieved, for example, as a power module controlling a drive power to a motor for controlling a drive of the motor serving as an actuator for actuating a caliper, in an electro mechanical brake apparatus.

Fig. 2 is a schematic view showing an assembled state of the integrated circuit apparatus to a resin casing.

A resin casing 4 is constituted, for example, by a resin casing constructing a control unit of an electro mechanical brake apparatus, and is provided with a metal bus bar 5 forming a wiring for supplying a signal or an electric power. The bus bar 5 serving as a conductor plate is molded, for example, to the resin casing 4, and is provided in such a manner that a part thereof is exposed from the resin casing 4.

A welding operation portion 3 corresponds to a bonded portion between the terminal 2 of the integrated circuit apparatus and the bus bar 5. The terminal 2 is bonded to the bus bar 5 in the exposed portion of the bus bar 5 in accordance with a welding, and is mounted to an inner portion of the resin casing 4.

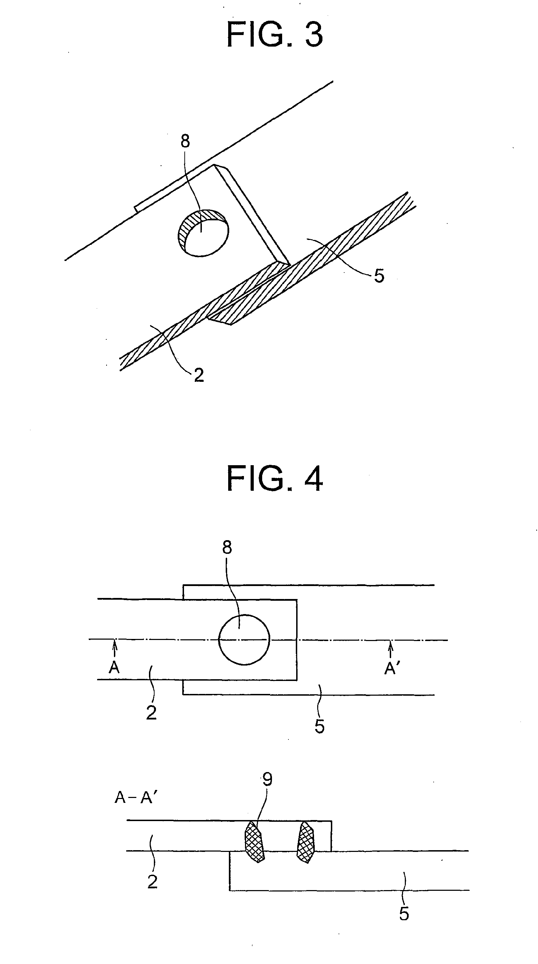

Fig. 3 is an enlarged perspective view of the welding operation portion 3, and Fig. 4 is a top elevational view and a cross sectional view of the welding operation portion.

As mentioned above, the terminal 2 is provided with a circular hole 8 in a portion lapping over the bus bar 5 at a time of welding. The hole 8 mentioned above can be molded in a lump, for example, at a time of press molding the terminal 2.

As is apparent from the top elevational view shown in Fig. 4, the terminal 2 has a shape characteristic in the hole 8 provided in the terminal 2, and can be positioned in accordance with an image recognition. It is possible to apply various existing image recognition techniques to the image recognition. At a time of bonding, both the elements are bonded by irradiating a laser welding arc to a peripheral edge portion of the hole 8 recognized by the image recognition, and welding the surface of the bus bar 5 positioned at the edge portion or near the same. A melt portion in a weld position 9 around the hole 8 reaches the bus bar 5, and is bonded to the terminal 2, as shown in the cross sectional view in Fig. 4 by bonding the terminal 2 and the bus bar 5 as mentioned above. The laser welding arc irradiated at this time may be irradiated to a whole of the peripheral edge portion of the hole 8, or may be irradiated to several positions on a circumference of the hole 8 in a spot manner as far as a strength is obtained. In the portion having a comparatively small calorific capacity such as the edge portion, it is possible to easily melt down the portion, and it is possible to securely execute the connection between the terminal 2 and the bus bar 5.

Generally, it is hard to apply the laser welding to a luster surface, and it is desirable to set the terminal 2 in a bronze base metal state. Since the terminal 2 is exposed to a high-temperature and highpressure environment at a time of sealing the main body portion 1 by resin, a surface color thereof takes on a rust-like aspect due to a combustion. However, in the present embodiment, since the welding between the terminal 2 and the bus bar 5 is executed by utilizing the hole 8 provided in the terminal 2, it is hard to be affected by the surface state of the weld portion, and it is possible to execute a stable welding.

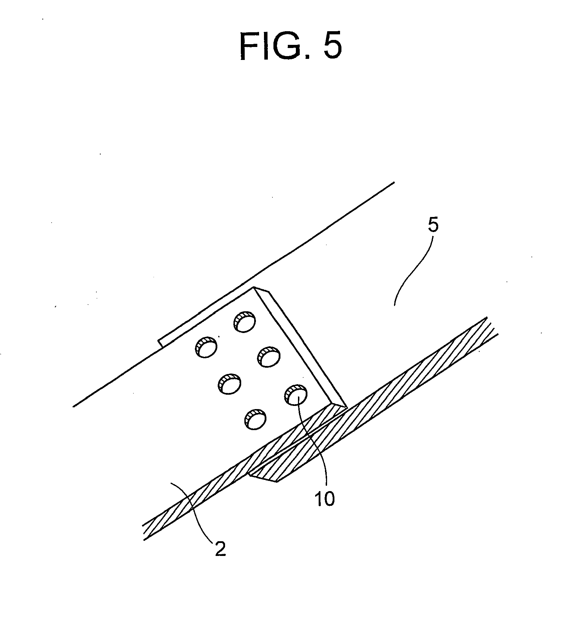

Fig. 5 is an enlarged perspective view of a welding operation portion in accordance with a second embodiment of the present invention.

In the present embodiment, a plurality of holes 10 are provided in the terminal 2. A diameter of each of the holes 10 is smaller than a laser diameter of the irradiated laser beam. A number, a layout and the like of the holes 10 are determined in accordance with the shapes of the terminal 2 and the bus bar 5, and a strength required in the welding operation portion. Specifically, it is possible to make the weld strength greater by increasing the number of the holes provided in a width direction and a length direction of the welding operation portion so as to increase the welded positions.

Embodiment 2

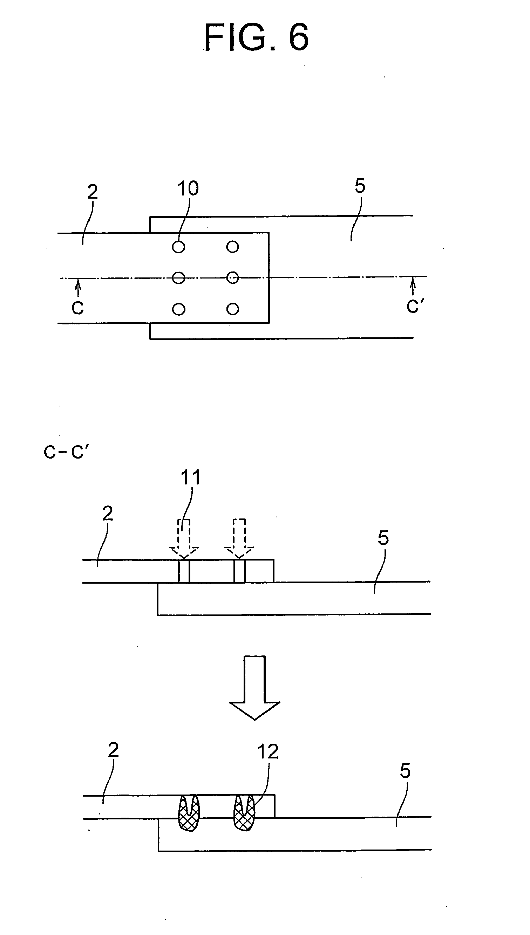

Fig. 6 is a top elevational view and a cross sectional view of a welding operation portion in accordance with a second embodiment.

In the present embodiment, since the hole 10 has the shape characteristic, it is possible to position on the basis of the image recognition. A weld position 12 melting around the hole 10 reaches the bus bar 5 by irradiating a laser welding arc 11 to the hole 10 recognized on the basis of the image recognition, whereby a bonding to the terminal 2 is achieved. Since the diameter of the laser welding arc 11 irradiated at this time is larger than the hole 10, it is possible to weld one hole 10 by one irradiation. In other words, in the case that the hole 10 is provided at six positions, as illustrated, six times of laser irradiations are executed.

Embodiment 3

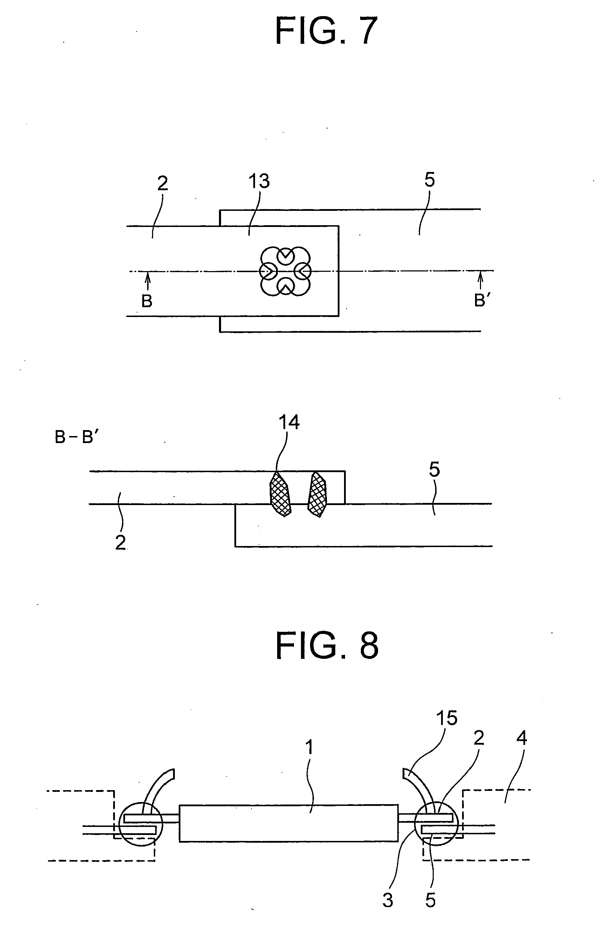

Fig. 7 is a top elevational view and a cross sectional view of a welding operation portion in accordance with a third embodiment of the present invention.

In the present embodiment, a hole 13 provided in the terminal 2 is provided with a projection portion toward an inner side thereof. The special shaped hole 13 is provided in a welding operation portion lapping over the bus bar 5 in the terminal 2. As shown in the top elevational view in Fig. 7, since the special shaped hole 13 has a shape characteristic, it is possible to position on the basis of the image recognition. A weld position 14 formed by melting a projection of the special shaped hole 13 reaches the bus bar 5 so as to be bonded to the terminal 2, by irradiating the laser welding arc to the special shaped hole 13 recognized on the basis of the image recognition. At this time, the number and the layout of the projections directed to the inner side of the hole can be optionally set.

In the embodiments described above, the irradiating time of the laser welding arc is generally an extremely short time, and it is possible to move the laser irradiation position to several positions in a short period of time. Further, the hole shape provided in the terminal can be formed by a press molding of the terminal, the welding is positioned on the basis of the image recognition by using the hole shape, and the edge portion is melted. Accordingly, it is possible to achieve a stable weld quality at a low cost regardless of an outer appearance state of the welded portion and even in the terminal having a certain degree of thickness.

In this case, the hole 8, the hole 10 and the hole 13 in accordance with the embodiments mentioned above may be formed in a taper shape in which a hole diameter becomes smaller in a direction of the bus bar from the laser irradiation side. In this case, there is obtained an effect that the laser weld position of the terminal becomes thinner so as to be easily melted, and it is possible to avoid a reduction of a extraction rate.

Embodiment 4

Fig. 8 is a schematic view showing a terminal fixing state using a fixing member at a time of assembling an integrated circuit apparatus to a resin casing in accordance with a fourth embodiment of the present invention.

In this case, there is considered, for example, a mounting to a control unit, particularly to a resin casing having a bus bar built-in. In other words, there is considered a case that the resin casing built-in bus bar 5 wired to the inner portion of the resin casing 4 is partly exposed from the surface of the resin casing 4, and the exposed portion is welded to the terminal 2 of the integrated circuit main body portion 1 sealed by a plastic molding. At this time, a description will be given next of details of the fixing member 15 fixing the terminal 2.

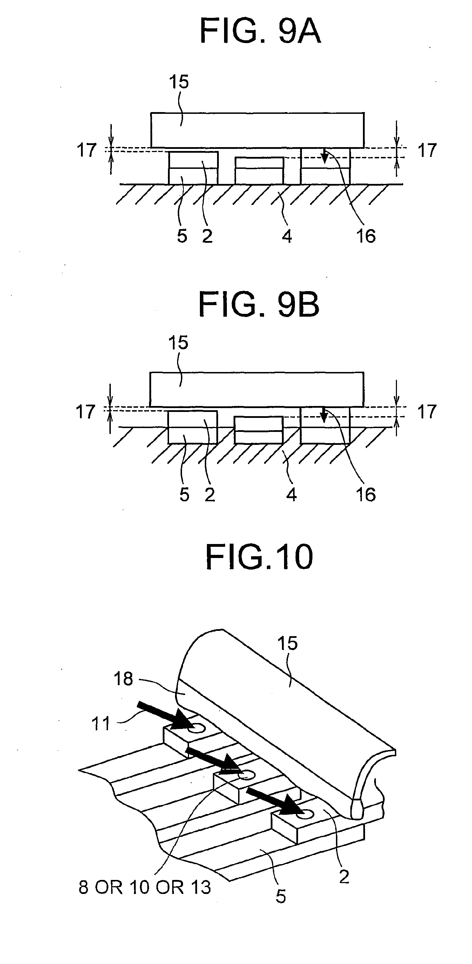

Figs. 9A and 9B are cross sectional views showing a fixed state of the fixing member 15 by a rigid body.

This drawing is on the assumption of a case viewing the fixing member 15, the terminal 2 and the bus bar 5 in Fig. 8 from a right side in the drawing. A plurality of terminals 2 of the integrated circuit main body portion 1 exist as shown in Fig. 1, and are arranged side by side. The bus bars 5 to which the respective terminals 2 are welded are arranged side by side in such a manner as to correspond to the respective terminals 2. In this case, for example, it is assumed that the fixing member 15 is constituted by a member having a small elastic deforming amount such as a metal material, and the overlapping portions of the terminals 2 and the bus bars 5 at a plurality of weld positions are pressed by the fixing member as shown in Fig. 9A. In this case, since the thickness at a time of overlapping the terminal 2 and the bus bar 5 is different at each of the positions, due to a dispersion generated in the thickness of each of the terminals 2 and each of the bus bars 5, a terminal pressing force 16 by the fixing member 15 is generated at a position in which a total thickness of the thicknesses of the terminal 2 and the bus bar 5 is largest. On the other hand, a gap 17 is generated between the terminal 2 and the fixing member 15 at a position in which the thickness is smaller than the thickness mentioned above. Accordingly, the pressing force 16 is not applied. In the case mentioned above, it is impossible to secure the contact between the terminal 2 and the bus bar 5, and if the welding is executed in the state mentioned above, the bonding between the both becomes incomplete. Fig. 9A shows a case that the bus bar 5 is fixed onto the resin casing 4 in a uniform thickness, however, there is a possibility that the dispersion of the thickness is generated in the bus bar 5 itself, and in the case that both of the terminal 2 and the bus bar 5 have the small thicknesses such as a combination in a center of Fig. 9B, the gap 17 becomes larger than a combination in a center of Fig. 9A. Further, there is shown the embodiment in which the bottom surface of the bus bar 5 is fixed at the same depth by the resin casing 4, however, there is a possibility that the bottom surface itself is dispersed in some attaching way of the bus bar 5, and the possibility of the incomplete bonding becomes further higher as mentioned above.

Further, in the case that the dimension and the shape are not aligned uniformly through the production period, it is necessary to press the position one by one in accordance with a manual operation, and weld while adjusting the pressing force 16 or the like. In the case that the quantity is much such as a mass production line, or in the case that the number of the weld terminal 2 is much, there can be easily forecasted a cost increase due to too much adjusting time of the welding condition, or a extraction rate deterioration due to an increase of the quality dispersion by the welding under the fixed condition.

Fig. 10 shows a perspective view in the case that an elastic body 18 is provided in the fixing member 15 while taking the above matter into consideration. It is possible to fix and contact in a lump by bridging the elastic body 18 over a plurality of combinations of the terminals 2 and the bus bars 5 as mentioned above, and pressing the terminal 2 and the bus bar 5 by the elastic body 18, and it is possible to immediately execute the laser welding by irradiating the laser beam onto the contact position.

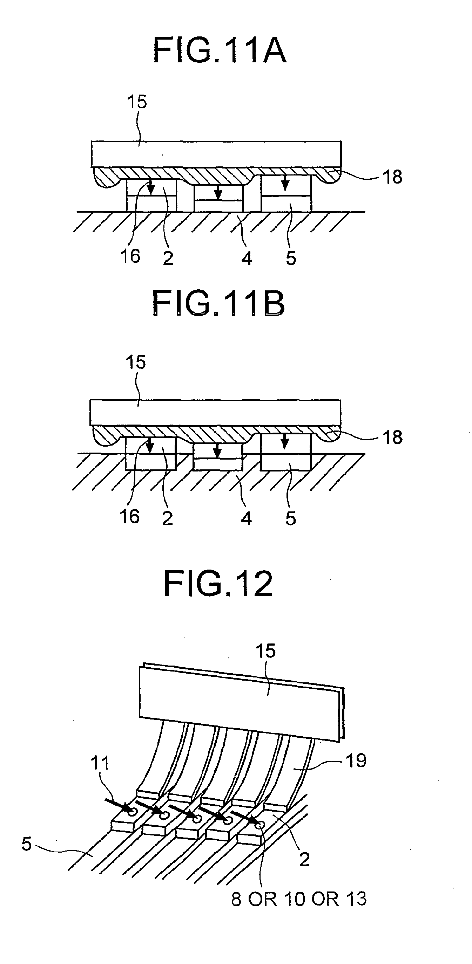

Fig. 11 shows a cross sectional view of the fixed state in Fig. 10.

The terminal 2 and the bus bar 5 are overlapped and fixed, and the fixing member 15 is pressed from the above of the terminal 2. In this case, the elastic body 18 is provided in a leading end of the fixing member 15, that is, a contact portion with the terminal 2, and the terminal 2 is pressed by the portion. On the basis of the elastic body 18, the elastic body 18 is closely attached to the terminal 2 at a plurality of weld positions, it is possible to absorb the dispersion of the thicknesses of the terminal 2 and the bus bar 5, and it is possible to uniformly press the terminal 2 at each of the weld positions. As a result, the terminal 2 and the bus bar 5 are brought into contact with each other. The terminal 2 and the bus bar 5 can be melted and bonded by irradiating the laser welding arc 11 in this state. In other words, it is possible to always secure the weld strength, and it is possible to maintain a stable weld state.

With regard to the elastic body 18, it is preferable to employ a material which does not damage the surface of the weld terminal, for example, a rubber. Further, the elastic body is made of a material which can be arranged in a straight line in a perpendicular direction to a longitudinal direction of the bus bar, and presses a plurality of terminals 2 and bus bars 5 on the basis of a restorative force generated by an elastic deformation at a time of pressing.

In this case, there is shown the embodiment in which the terminal 2 and the corresponding bus bar 5 thereto are arranged side by side, however, it is not necessary that they are arranged side by side, but it is possible to employ every positional relations of the combination between the terminal 2 and the bus bar 2, as far as the fixing member 15 and the elastic body 18 are formed in such a manner as to bridge over a plurality of terminals 2 and bus bars 5. The same matter is applied to the following embodiments.

Further, there is shown the embodiment in which the terminal 2 is pressed to the bus bar 5 so as to be welded, however, the bus bar 5 may be inversely pressed to the terminal so as to be welded. This matter is applied to all the embodiments described in the present application.

Embodiment 5

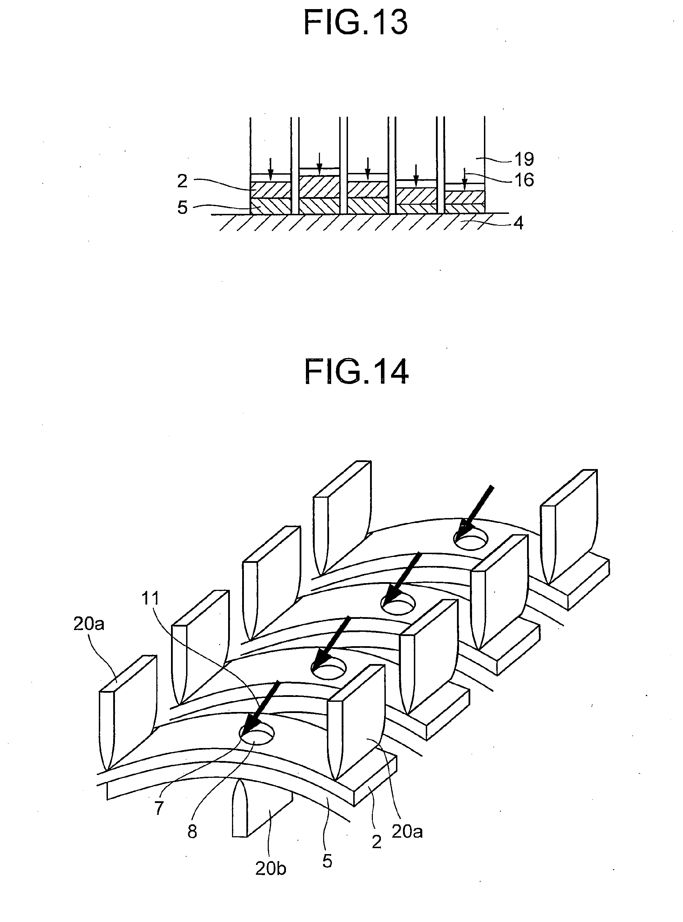

Fig. 12 shows a perspective view of a weld position in accordance with a fifth embodiment.

There are arranged uniformly a plurality of flat plates 19 having an elasticity and having the same plate width as that of the terminal 2, and the plates 19 are added to one fixing member 15. At a time of fixing, the flat plates 19 are pressed to the terminal 2 from the above of the terminal 2 in such a manner as to bend in a longitudinal direction. At this time, since a restorative force is generated on the basis of an elastic deformation in the flat plates 19, the pressing force 16 is generated so s to press the terminal 2.

Fig. 13 shows a cross sectional view of a fixed state in Fig. 12.

The fixing member 15 having the flat plate 19 is pressed to a portion near the welding operation portion 3. At this time, the flat plates 19 are arranged in one sheet per one terminal, overlap the terminal 2 and the bus bar 5, and press both the elements. Accordingly, it is possible to absorb the gap 17 between the terminal 2 and the fixing member 15 generated on the basis of the dispersion of the thickness included in the terminal 2, and it is possible to obtain a uniform pressing force 16. Further, since it is possible to fix a plurality of terminals in a lump, it is possible to execute the laser welding in a lump after fixing.

Embodiment 6

Fig. 14 shows a perspective view of a weld position in accordance with a sixth embodiment.

The terminal 2 and the bus bar 5 are pressed by two kinds of fixing members 20a and 20b. In this case, there is considered a case that the bus bar 5 is not supported by the resin or the like at the weld position, but is exposed. In other words, it is the case that the bus bar 5 wired in the inner portion of the resin casing 4 protrudes from the surface of the resin casing 4 so as to be exposed, and the bus bar 5 is welded to the terminal 2 of the integrated circuit main body portion 1 sealed by a plastic molding. At this time, the fixing members 20a and 20b fixing the terminal 2 or the bus bar 5 are shown below.

At a time of overlapping the terminal 2 and the bus bar 5, and melting the material by irradiating the laser welding arc 11 to the terminal hole 8, for example, a circular through hole, which corresponds to a characteristic shape included in the terminal 2, the upper fixing member 20a is pressed at a plurality of positions in the terminal 2 side, and the bus bar 5 side is pressed at only one position by using the lower fixing member 20b.

In this case, with regard to the position at which the fixing members 20a and 20b are pressed, in the case that the upper fixing member 20a is fixed at two positions in the laser irradiation side, the upper fixing member 20a is arranged in such a manner as to pinch the weld position, and the lower fixing member 20b is arranged in such a manner as to press the weld point (the weld position 7) in the bus bar side, in the inverse side to the laser irradiation side.

On the other hand, in the case that the upper fixing member 20a is pressed at a plurality of positions, the weld position 7 is arranged in a center of a shape structured by connecting the upper fixing members 20a to each other by a straight line, for example, a point of a center of gravity of a triangle, and the lower fixing member 20b is arranged in a back surface of the weld position 7 in the bus bar side so as to be fixed. Further, the laser welding arc 11 is irradiated to the point of the center of gravity.

On the basis of the fixing method, it is possible to secure the contact between the bus bar 5 and the terminal 2, and it is possible to execute the laser welding which secures a stable weld state and weld strength.

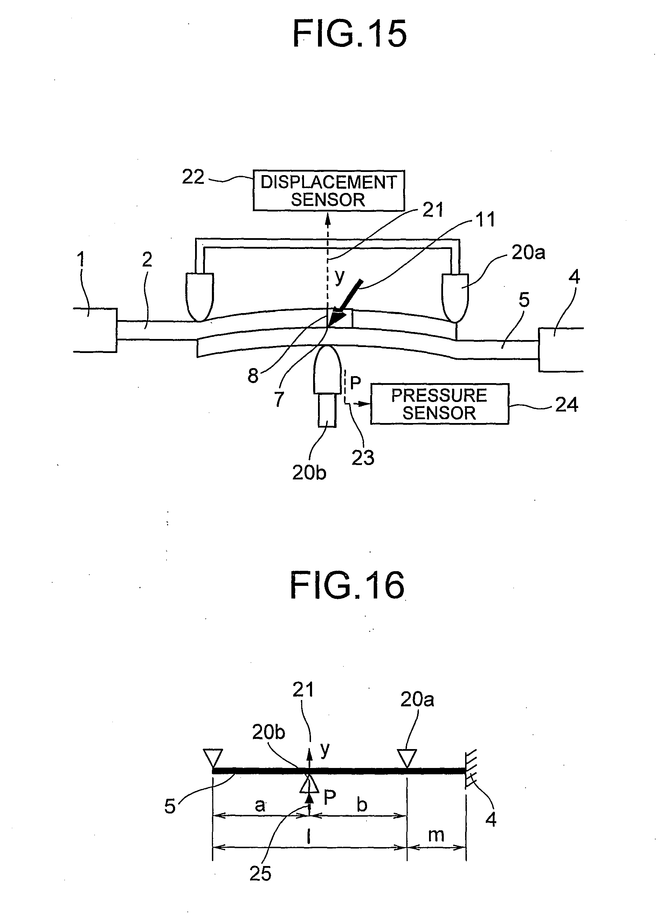

Fig. 15 is a schematic view of a welding apparatus using the fixing method in Fig. 14.

For example, considering a state in which the bus bar 5 and the terminal 2 are not supported near the weld position 7, the upper fixing member 20a is arranged in such a manner as to pinch the welding operation position in the terminal 2, the lower fixing member 20b is arranged in the lower surface in the bus bar 5 side of the welding operation position, and the terminal 2 and the bus bar 5 are pinched. At this time, the upper fixing member 20a only plays a role of fixing the terminal 2, and the lower fixing member 20b presses the bus bar 5 in a direction of bringing the bus bar 5 into contact with the terminal 2.

At this time, the pressing force of the lower fixing member 20b is measured by a pressure sensor 24, and a displacement amount 21 of the terminal 2 caused by the pressing force is measured by a displacement sensor 22. By using these two information, for example, it is possible to obtain the following laser welding apparatus.

If the bus bar 5 is pressed by using the lower fixing member 20b, the pressing force is generated. The pressing force at this time is detected by using the pressure sensor 24. Further, since the terminal 2 and the bus bar 5 are deformed by the pressing force, the displacement amount of the terminal 2 by the lower fixing member 20b at this time is detected by using the displacement sensor 22.

In this case, in order to determine the fact that the terminal 2 and the bus bar 5 are brought into contact with each other, a threshold value is optionally set with respect to at least one of the pressing force and the displacement amount 21 in the contact state, the current measured value is compared with the threshold value in accordance with a method such as an automatic recognition or the like, the laser welding arc 11 is irradiated at a time point of determining that the value is larger than the threshold value, and the terminal 2 is bonded to the bus bar 5.

In accordance with the welding method mentioned above, it is possible to set an irradiation timing of the laser welding arc 11 at a time of welding a plurality of positions. Further, since the weld position 7 which gets over the threshold value can be detected by the pressure sensor 24 and the displacement sensor 22, it is possible to weld under the same condition even if the pressing force is different in each of the welding operation portions.

As a result, it is possible to execute a stable welding under an optimum condition in each of the weld positions, and it is possible to sufficiently secure the weld strength.

Fig. 16 shows a theoretical explanation about the threshold value of the pressing force and the displacement amount of the welding apparatus in Fig. 15.

When the displacement 21 of the terminal is set to y, a relation between the positions of the terminal 2 or the bus bar 5 and the upper and lower fixing members 20a and 20b and the deformation amount by the pressing force 25 can be indicated by the following relational expression in an elastic region and a small deformation region.

$$y = \frac{a}{61EI}\left[P_b(a^1 - a^2 - b^2) + M(1^2 - a^2)\right]$$

$$M = \frac{2P_b}{(41-3m)}(21^2 + b^2 - 3b1)$$

In this case, reference symbol E denotes a Young's modulus, and reference symbol I denotes a geometrical moment of inertia.

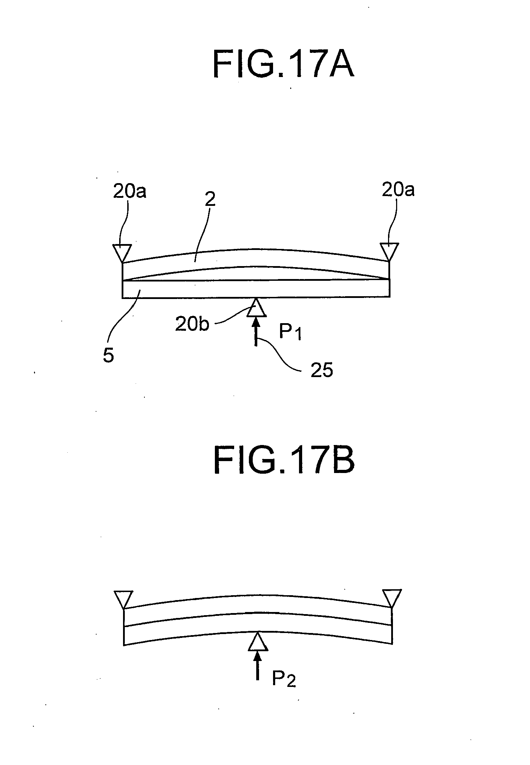

Fig. 17 is a schematic view for explaining a contact state of the laser welding with regard to the fixing method shown in Fig. 14.

With regard to the pressing force 25, a force deforming only the bus bar 5 is set to P1, and a force deforming the bus bar 5 and the terminal 2 is set to P2. First, since only the bus bar 5 is deformed in an initial stage that the lower fixing member 20b is pressed, the pressing force 25 is P1. Further, in the case of pressing at a constant speed, the bus bar 5 and the terminal 2 are brought into contact with each other, and the geometrical moment of inertia I and the support state are changed, so that the pressing force 25 is changed to the force P2 deforming the bus bar 5 and the terminal 2. It is possible to determine on the basis of the change of the pressing force 25 whether or not the bus bar 5 and the terminal 2 are brought into contact with each other. Accordingly, the contact state is set by setting the force P2 as the threshold value of the pressing force 25, always detecting the pressing force 25 by the sensor, and comparing with the force P2.

Further, since the deforming state of the material can be determined in accordance with (expression 1), the contact state can be also determined by setting the theoretical value of the displacement amount 21 as the threshold value, and comparing with an actual measured value, in the same manner as the pressing force 25.

The laser welding apparatus mentioned above has a characteristic that the contact can be recognized before the welding operation, and it is possible to improve a weld quality of the product using the laser welding.

Embodiment 7

Next, a description will be given of an embodiment of a control unit of an electro mechanical brake as one example of the control unit for the vehicle manufactured by the embodiment mentioned above.

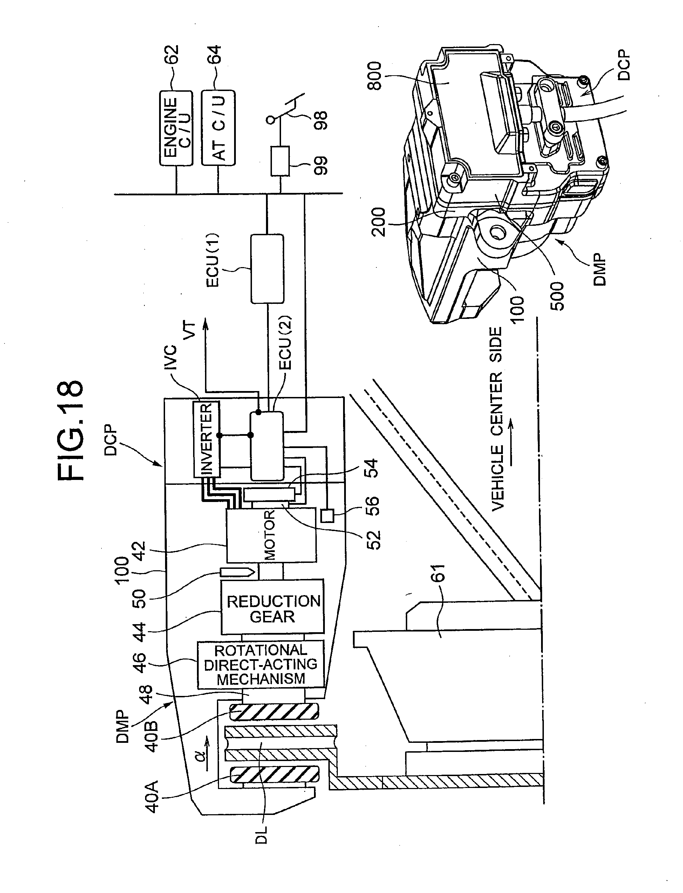

Fig. 18 shows an internal structure view and a perspective view of an electro mechanical brake in accordance with an embodiment of the present invention.

The electro mechanical brake is constituted by a caliper DMP having brake pads 40A and 40B generating a friction with respect to a brake disc DL, a piston 48 propelling the brake pad 40B, a motor 42 generating a thrust of the piston 48, and a rotation direct-acting motion conversion mechanism 46 converting a rotation of the motor 42 into a direct-acting motion of the piston 48, in an inner portion of a casing 100, and a controller portion DCP having an inverter IVC driving the motor 48, and a control circuit ECU (2) switching the inverter IVC, and the caliper DMP and the controller portion DCP are integrated. Further, the electro mechanical brake has a parking brake mechanism 50, a rotation angle detecting sensor 52, a thrust sensor 54 and a motor temperature sensor 56. Reference numeral 61 denotes a structure member in the vehicle side. Further, a power is supplied to the electric circuit portion DCP of the electro mechanical brake apparatus from a battery VT arranged in an outer portion of the electro mechanical brake apparatus, and a control signal is supplied to the electric circuit portion DCP via an engine control unit 62, an automatic transmission control unit 64, and a local area network (LAN) to which a detector 99 detecting a pedaling force of the brake pedal 98 or the like is connected, or via the control apparatus ECU (1) from the LAN.

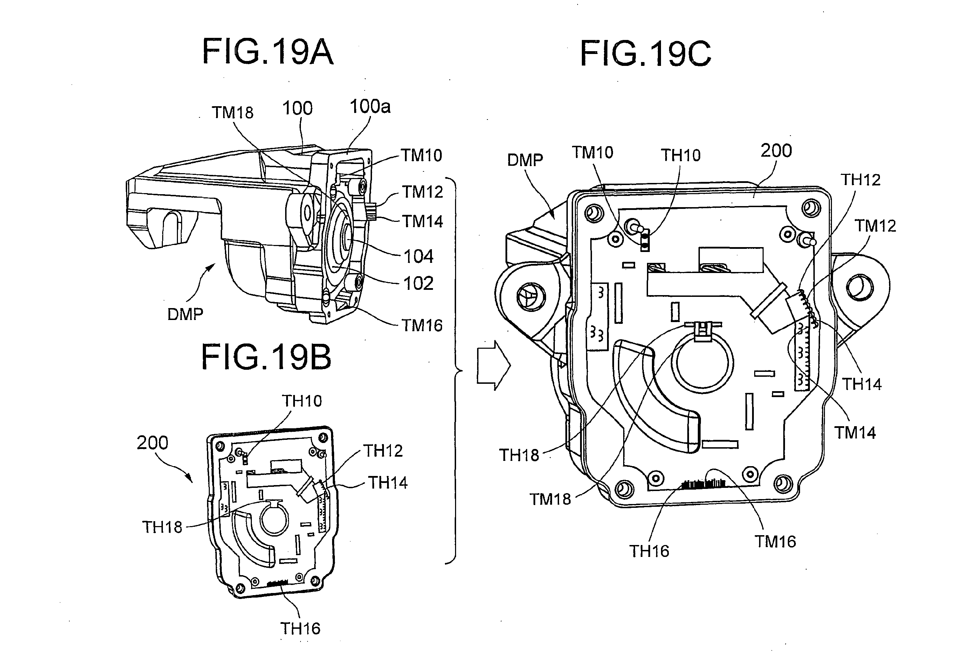

Fig. 19 shows a connection diagram between the caliper DMP in Fig. 18 and an interface module 200.

An aspect of the integration is as follows, for example. First, the bus bars TM10, TM12, TM14, TM16 and TM18 extending from the caliper DMP is connected to the bus bars TH10, TH12, TH14, TH16 and TH18 accommodated in the interface module 200 in accordance with the welding or the like. Further, the casing DCP accommodating the control portion is provided in an inverse side from the caliper DMP while holding the interface module 200 therebetween.

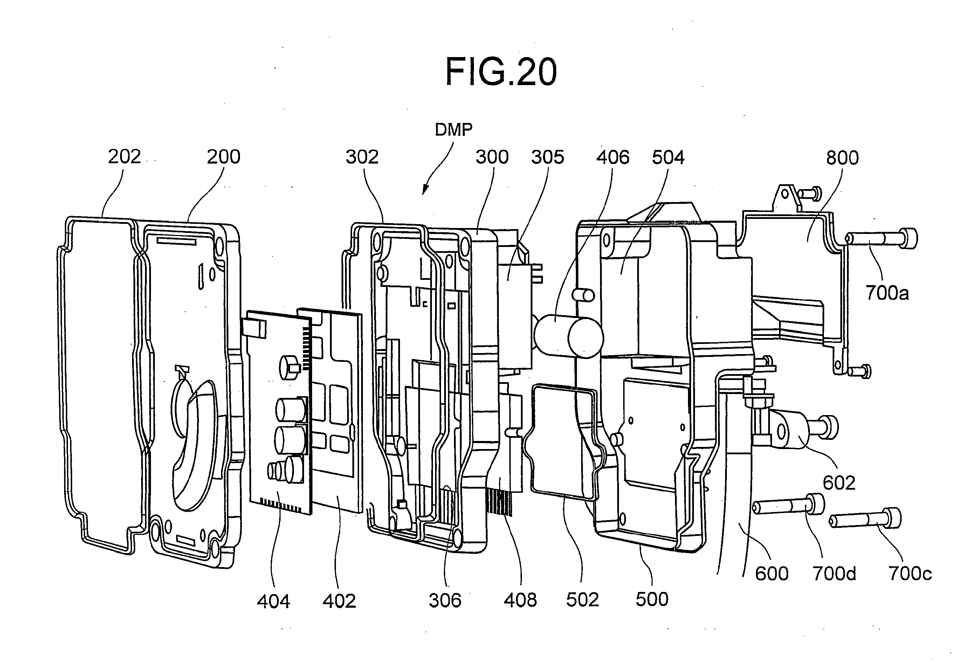

Fig. 20 shows a connection diagram between the interface module 200 in Fig. 18 and the casing DCP, and is a perspective view showing each of the constituting members of the electric circuit portion DCP in an enlarged manner. Each of the constituting members will be schematically shown below in relation to the other constituting members.

First, there is the interface module 200 attached to the casing of the mechanism portion DMP mentioned above. The interface module 200 is constituted by a synthetic resin, for example, polyphenylene sulfide (PPS) or the like.

For example, a seal 202 is arranged in the periphery of a surface close to the mechanism portion DMP in the interface module 200 in such a manner as to surround a center portion except the periphery, and the structure is made such that the interface module 200 is attached to the casing of the mechanism portion DMP via the seal 202. It is possible to prevent a water content, a foreign material or the like from making an intrusion from a portion between the mechanism portion DMP and the interface module 200, by the seal 202.

The interface module 200 has a function serving as a wiring board for electrically leading out a terminal (not shown) arranged in the side of the mechanism portion DMP to the opposite side surface to the mechanism portion DMP. A terminal (not shown) positionally defined in relation to a wiring formed in an inner case 300 mentioned later is planted on an opposite side surface to the mechanism portion DMP in the interface module 200.

Further, there is the inner case 300 attached to the interface module 200. The inner case 300 is constituted by a synthetic resin, for example, PPS or the like. A seal 302 is arranged around a surface close to the interface module 200 in the inner case 300 in such a manner as to surround a center portion except the periphery, and the structure is made such that the inner case 300 is attached to the interface module 200 via the seal 302. It is possible to prevent the water content, the foreign material or the like from making an intrusion from the portion between the interface module 200 and the inner case 300, by the seal 300.

The inner case 300 has a function of mounting an electronic part thereon, and a metal plate 402, for example, constituted by an aluminum plate (AL plate) and a control circuit board 404 are mounted on the surface close to the interface module 200 so as to be overlapped sequentially. The control circuit board 404 is constituted, for example, by a ceramic, and the metal plate 402 is provided for avoiding a damage, for example, caused by a torsion or the like of the control circuit board 404. The control circuit board 404 corresponds to a three-phase motor prediver circuit.

In this case, a concave portion (not shown) is formed in the other portions than a peripheral portion including the seal 302 on the facing surfaces to each other of the inner case 300 and the interface module 200, and the metal plate 402 and the control circuit board 404 are arranged within the concave portion so as to be accommodated between the inner case 300 and the interface module 200.

Further, a wall portion 305 is formed in an opposite side surface to the interface module 200 of the inner case 300, in such a manner as to surround one region of two regions obtained by separating the opposite side surface, and a comparatively large-scaled electronic part 406, for example, constituted by a capacitor, a reactance or the like is mounted in an inner portion of the wall portion 305. In the other region, a large through hole 306 having a comparatively large area is formed in a part of the region, and a power module 408 is arranged in an inner portion of the through hole 306. The power module 408 corresponds to a three-phase motor inverter circuit, a phase current monitor circuit and a phase-voltage monitor circuit, and is structured by molding these circuits.

Further, the structure is made such that an outer case 500 is attached to the opposite surface to the interface module 200 in the inner case 300. The outer case 500 is attached in such a manner as to open the electronic part mounting region in the inner portion of the wall portion 305 of the inner case 300 by an opening portion 504, and cover the other remaining regions, that is, a peripheral side surface of the inner case 300, a peripheral side surface of the wall portion 305 of the inner case 300, and the through hole 306 and the periphery thereof in which the power module 408 is arranged.

The outer case 500 is constituted by a metal, for example, an aluminum alloy, and is structured such as to cover most part of an outer peripheral surface of the electric circuit portion DCP by the outer case 500 so as to mechanically protect from an impact from an external portion.

In this case, the power module 408 is provided in such a manner that a heat radiation surface faces to the inner surface of the outer case 500 as shown in the drawing. A recess is provided in the outer case 500, and the power module 408 is arranged in a space formed with respect to the interface module 200 (mentioned below). Further, the control circuit board 404 which is weak against heat is provided in an inner portion of the outer case 500, and is arranged close to the mechanism portion DMP side with respect to the power module 408. In the case of viewing a whole of the electro mechanical brake apparatus, the structure is made such that a heat transmitting in the inner portion of the mechanism portion DMP in the heat on the friction surface between the disc rotor DL and the brake pads 40A and 40B is hard to be transmitted by the motor 42 and the gap (the space) as described in Fig. 4. Further, the heat generated from the power module within the electric circuit portion DCP is radiated to the outer side of the outer case 500 through an inner surface of the facing outer case 500. Accordingly, the control circuit board 404 arranged in the mechanism portion DMP side with respect to the power module 408 is structured such that the heat generated from each of the heat sources is hard to be transmitted, and is protected by the heat.

In this case, the structure is made such that the seal 502 is arranged in the portion facing to the through hole 306 of the inner case 300 and the periphery thereof on the surface close to the inner case 300 of the outer case 500, in such a manner as to surround the through hole 306. The seal 502 is provided, for example, such as to prevent the water content from making an intrusion into the surface close to the interface module 200 of the inner case 300 from the opening portion 504 of the outer case 500 through the through hole 306 of the inner case 300.

Further, a harness 600 for supplying a power or a control signal or the like from an external portion side of the electro mechanical brake apparatus is fixed to the outer case 500 by a harness stopper 602, and each of the wirings (not shown) within the harness 600 is conducted to the electronic part mounting region within the wall portion 305 through a through hole (not shown) formed in the wall portion 305 of the3 inner case 300.

The interface module 200, the inner case 300 and the outer case 500 structured as mentioned above are integrated by bolts 700a, 700b (not shown) 700c and 700d inserted to thread holes formed in four corners of each of the interface module 200, the inner case 300 and the outer case 500 from the outer case 500 side, and are mounted to the mechanism portion DMP.

Further, the opening portion 504 of the outer case 500 is covered by a cover 800 screwed to the outer case 500. The cover 800 is formed, for example, the metal such as the aluminum alloy or the like in the same manner as the outer case 500.

In the control unit of the electro mechanical brake as mentioned above, a laser welding operation position in accordance with the present invention will be shown below.

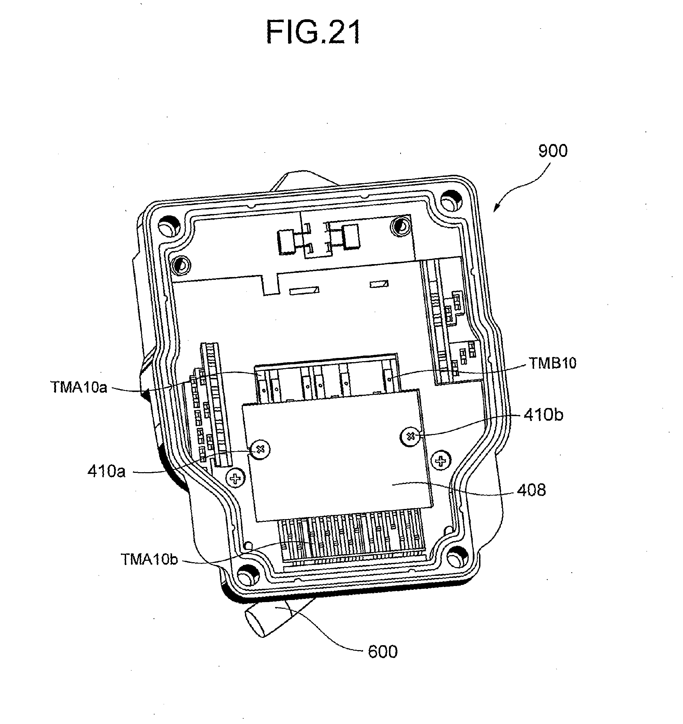

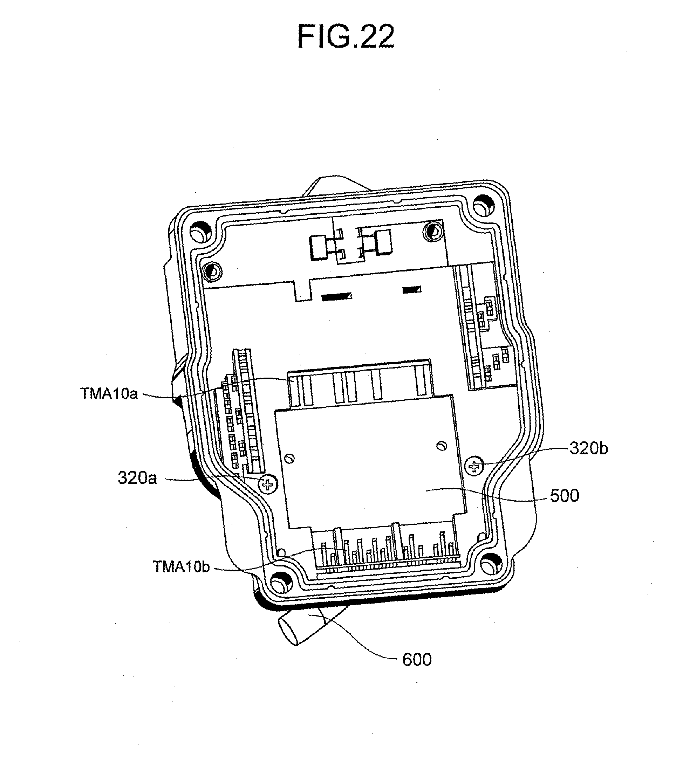

Figs. 21 and 22 show steps at a time of attaching the power module 408 to the inner case 300, in the embodiment in Fig. 18.

First, as shown in Fig. 21, there is prepared an electronic part mounting board 900 to which the harness 600 is attached, and the power module 408 is arranged in the portion of the through hole 306 in an inner side surface thereof, and is fixed by screws 410a and 410b screwed into thread holes 510a and 510b (not shown) formed in the outer case 500 through thread holes (not shown) formed in the power module 408.

In this case, a structure of a back surface of the inner case 300 before mounting the power module 408 is formed as shown in Fig. 22, the through hole 306 of the inner case 300 closed by the outer case 500 is formed as the concave portion, and the power module 408 is accommodated in the concave portion.

In this case, a portion corresponding to the bottom surface of the concave portion corresponds to a part of the outer case 500 formed by the metal, and the power module 408 is arranged in such a manner as to be brought into contact with the outer case 500. This is because the heat generat3ed from the power module 408 is radiated via the outer case 500. Further, although an illustration will be omitted, the structure is made such as to improve an efficiency of a heat transmission to the outer case 500 from the power module 408 by interposing a heat radiating grease or a heat radiating sheet between the outer case 500 and the power module 408.

Further, terminals TMB10a and TMB10b forming electrodes of the power module 408 are structured in a side surface of the power module 408 so as to be protruded, and in the case that the power module 408 is arranged at a fixed position on the inner case 300, the terminals TMA10a and TMA10b to be connected to the terminals TMB10a and TMB10b mentioned above are formed in such a manner as to be exposed to the inner case 300 surface. The terminals TMA10a and TMA10b are connected to a wiring layer, for example, embedded in the inner case 300.

In this case, the terminal TMB10b of the power module 408 and the terminal TMA10b on the inner case 300 surface respectively have an L-shaped form in leading ends thereof, hold the contact by confronting the leading ends to each other, and can be electrically connected, for example, by irradiating the laser beam. Further, the terminal TMB10a of the power module 408 has the terminal hole 8, for example, shown in Fig. 3, and is brought into contact with the terminal TMA10a on the inner case 300 surface by a plane, and the terminals are melted with each other by irradiating the laser beam to the terminal hole 8, and can be electrically connected.

As mentioned above, since the leading end of one terminal has the L-shaped form, and the leading end of the other terminal has the through hole, it is possible to position at the weld positions between the L-shaped forms, and the laser welding can be executed only by contacting with the welded terminal at the terminal-shaped position in accordance with the present embodiment without requiring the positioning. In other words, it is possible to dissolve the circumstance that the weld quality is deteriorated due to the dispersion of the shape of the terminal protruding from the power module 408, in spite that the power module 408 itself is positioned by the screws 410a and 410b, by forming the leading ends of the terminals TMB10a and TMB10b of the power module 408 in the different shapes, and it is possible to improve the positioning and welding quality without being affected by the dispersion of the terminal shape.

In this case, in the embodiment mentioned above, the description is given of the welding between the terminal of the control circuit and the bus bar of the inverter, however, it is possible to connect the bus bar extending from the sensor measuring the thrust of the piston, the rotational position of the motor, the temperature and the pressure around the motor and the piston, and the like, and the terminal of the control circuit, in accordance with the laser welding mentioned above.

The electro mechanical brake is provided unsprung of the vehicle, is connected to the other sprung controller, for example, an integrated brake controller, a vehicle dynamics control (VDC) unit or the like by a harness or the like, and is controlled in such a manner as to generate a brake force commanded from the other controllers. It is possible to reduce the number of the signal lines connected by the harness between the above of the spring and the below of the spring, by integrating the controller and the caliper. In the case that the caliper is provided below the spring and the controller is provided above the spring without integrating the controller and the caliper, for example, it is necessary to make the three-phase signal line of the inverter driving the motor in the inner portion of the caliper creep between the above of the spring and the below of the spring, so that there is increased a possibility of a cost and a fail due to various factors such as a noise countermeasure, a high-strength of the harness and the like. The problem mentioned above can be dissolved by integrating the caliper and the controller. On the other hand, since the electro mechanical brake is provided below the spring of the vehicle, the vibration from the ground is directly transmitted, and there is a possibility that the circuit is disconnected by the great vibration in the case that the connection of the circuit is achieved, for example, by a soldering or the same degree. On the contrary, in accordance with the laser welding mentioned above, the possibility of the disconnection of the circuit is widely reduced due to the high level of the weld quality, and there can be obtained an effect that the brake apparatus having a higher reliability can be provided.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

It should be further understood by those skilled in the art that although the foregoing description has been made on embodiments of the invention, the invention is not limited thereto and various changes and modifications may be made without departing from the scope of the appended claims.

**Claims**

1.  A method of a laser welding of laser welding a bus bar (5) provided within a resin casing (4)constituting a control unit mounted to a vehicle, and a terminal (2) of an integrated circuit inward surrounded within the control unit and sealed by a plastic molding, **characterized in that** a hole (8) is previously provided in a position to be welded to said bus bar corresponding to an end portion in said terminal, a positioning at a time of the laser welding is executed by image recognizing the hole, and said bus bar and said terminal are laser welded in a portion in which said hole is provided.

2.  A method of a laser welding as claimed in claim 1, **characterized in that** said hole (8) is formed in a circular shape or a similar shape thereto.

3.  A method of a laser welding as claimed in claim 1 or 2, **characterized in that** said laser welding melts an edge portion of said hole (8).

4.  A method of a laser welding as claimed in claim 2, **characterized in that** a diameter of said hole is equal to or less than a diameter of a laser beam used for said laser welding.

5.  A method of a laser welding as claimed in at least one of the preceding claims, **characterized in that** a plurality of said holes (8) are provided.

6.  A method of a laser welding as claimed in at least one of the preceding claims, **characterized in that** said hole is formed in a shape having a projection toward an inner side on a circumference of said hole.

7.  A manufacturing method of a control unit mounted to a vehicle **characterized in that** the method comprises the steps of:

    at a time of laser welding a terminal (2) of an integrated circuit provided in an inner portion of the control unit and sealed by a plastic molding, and a bus bar (5) transmitting an electric signal of said integrated circuit or supplying a power,
    previously setting a hole (8) in an end portion of said terminal corresponding to a welding operation position (3) to said bus bar, executing a positioning at a time of the laser welding by image recognizing the hole, and laser welding said bus bar and said terminal in a portion in which said hole is provided.

8.  A manufacturing method of a control unit mounted to a vehicle **characterized in that** the method comprises the steps of:

    at a time of laser welding a terminal (2) of an integrated circuit provided in an inner portion of the control unit and sealed by a plastic molding, and a bus bar (5) transmitting an electric signal of said integrated circuit or supplying a power,
    bringing said terminal and said bus bar into contact with each other by pressing a plurality of combinations of said terminals and said bus bars by a fixing member (15), and welding said terminal and said bus bar irradiating a laser beam to the contact position of said terminal or said bus bar.

9.  A manufacturing method of a control unit as claimed in claim 8, **characterized in that** said fixing member (15) is constituted by an elastic body (18), the elastic body is arranged in such a manner as to bridge over the plurality of combinations of said terminals (2) and said bus bars (5) to be welded, said terminals and said bus bars are brought into contact with each other by pressing a plurality of said terminals or said bus bars on the basis of a restorative force generated by an elastic deformation at a time of pressing, and said terminal and said bus bar are welded by irradiating the laser beam to the contact position of said terminal or said bus bar.

10. A manufacturing method of a control unit as claimed in claim 8, **characterized in that** said fixing member (15) is constituted by a plurality of flat plates (19) having approximately the same width as said terminal (2) or said bus bar (5) and arranged in such a manner that a force is applied to an individual combination of said terminal and said bus bar to be welded, said terminals and said bus bars are brought into contact with each other by pressing a plurality of said terminals or said bus bars on the basis of a restorative force generated by an elastic deformation at a time of pressing, and said terminal and said bus bar are welded by irradiating the laser beam to the contact position of said terminal or said bus bar.

11. A manufacturing method of a control unit mounted to a vehicle **characterized in that** the method comprises the steps of:

at a time of laser welding a terminal (2) of an integrated circuit provided in an inner portion of the control unit and sealed by a plastic molding, and a bus bar (5) transmitting an electric signal of said integrated circuit or supplying a power,
pressing said terminal or said bus bar in such a manner as to pinch a weld point by a plurality of first fixing members (20a) in a laser irradiation surface, pressing the weld point of said terminal or said bus bar by a second fixing member (20b) in an inverse side to the laser irradiation side so as to bring said terminal and said bus bar into contact with each other, and irradiating a laser beam to the contact position of said terminal or said bus bar, thereby welding said terminal and said bus bar.

12. A manufacturing method of a control unit as claimed in claim 11, **characterized in that** said terminal (2) and said bus bar (5) are welded by detecting the pressing force of said second fixing member (20b), and irradiating the laser beam to said contact position at a time when the pressing force gets over a predetermined threshold value.

13. A manufacturing method of a control unit as claimed in claim 11, **characterized in that** said terminal (2) and said bus bar (5) are welded by detecting a displacement amount of said terminal and said bus bar, and irradiating the laser beam to said contact position at a time when the displacement amount gets over a predetermined threshold value.

14. A car electronic control unit **characterized in that** the unit comprises:

a terminal (2) of an integrated circuit provided with a hole (8) at a welded position; and
a bus bar (5) electrically connected to said terminal and transmitting an electric signal of said integrated circuit or supplying a power, said bus bar in which a laser irradiation position is positioned by recognizing an image of said hole of the terminal of said integrated circuit, and being welded to said terminal by irradiating said laser beam to the portion provided with said hole.

15. A car electronic control unit as claimed in claim 14, **characterized in that** said control unit is constituted by a control unit integrated with an electro mechanical brake caliper provided below a spring of a vehicle so as to control the electro mechanical brake caliper, said integrated circuit is constituted by a control circuit of a motor changing a thrust of a piston pressing a pad of said electro mechanical brake, and said bus bar (5) is constituted by a bus bar connecting between the terminal (2) of said integrated circuit and a switching circuit of an inverter driving said motor.

16. A car electronic control unit **characterized in that** the unit comprises:

a plurality of terminals (2) of an integrated circuit sealed by a plastic molding;
a plurality of bus bars (5) electrically connected to said plurality of terminals, respectively and transmitting an electric signal of said integrated circuit or supplying a power, said bus bars being brought into contact with said terminals by being pressed by a fixing member (15) together with said terminals, and being welded to said terminals by a laser beam irradiated to the contact position.

17. A car electronic control unit as claimed in claim 16, **characterized in that** said control unit is constituted by a control unit integrated with an electro mechanical brake caliper provided below a spring of a vehicle so as to control the electro mechanical brake caliper, said integrated circuit is constituted by a control circuit of a motor changing a thrust of a piston pressing a pad of said electro mechanical brake, and said bus bar (5) is constituted by a bus bar connecting between the terminal (2) of said integrated circuit and a switching circuit of an inverter driving said motor.

**18.** A car electronic control unit **characterized in that** the unit comprises:

a terminal (2) of an integrated circuit sealed by a plastic molding;
a bus bar (5) electrically connected to said terminal, and transmitting an electric signal of said integrated circuit or supplying a power, said bus bar being pressed together with said terminal in a laser irradiation surface in such a manner as to pinch a weld point by a plurality of first fixing members (20a), brought into contact with said terminal by being pressed at the weld point by a second fixing member (20b) together with said terminal, and being welded to said terminal by a laser beam irradiated to the contact position.

**19.** A car electronic control unit as claimed in claim 18, **characterized in that** said control unit is constituted by a control unit integrated with an electro mechanical brake caliper provided below a spring of a vehicle so as to control the electro mechanical brake caliper, said integrated circuit is constituted by a control circuit of a motor changing a thrust of a piston pressing a pad of said electro mechanical brake, and said bus bar (5) is constituted by a bus bar connecting between the terminal (2) of said integrated circuit and a switching circuit of an inverter driving said motor.

# FIG. 1

# FIG. 2

# FIG. 3

8

5

2

# FIG. 4

8

A    A'

2

5

A-A'

9

2

5

# FIG. 5

# FIG. 6

C-C'

# FIG. 7

# FIG. 8

## FIG. 9A

## FIG. 9B

## FIG.10

# FIG.11A

# FIG.11B

# FIG.12

8 OR 10 OR 13

# FIG.13

# FIG.14

# FIG.15

# FIG.16

# FIG.17A

20a     2                  20a

20b   P1

5

25

# FIG.17B

P2

# FIG.18

FIG.19A

FIG.19C

FIG.19B

EP 1 835 791 A2

# FIG.20

# FIG.21

# FIG.22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11215652 A
- JP 11297445 A

- JP 10263838 A